(19) Europäisches Patentamt

European Patent Office

Office européen des brevets

(11) **EP 3 861 616 B1**

(12) **FASCICULE DE BREVET EUROPEEN**

(45) Date de publication et mention de la délivrance du brevet:
**30.11.2022 Bulletin 2022/48**

(21) Numéro de dépôt: **19795292.2**

(22) Date de dépôt: **01.10.2019**

(51) Classification Internationale des Brevets (IPC):
*H02J 3/14* (2006.01)          *H02J 13/00* (2006.01)
*H04L 12/28* (2006.01)

(52) Classification Coopérative des Brevets (CPC):
**H02J 3/14; H02J 13/00004; H02J 13/00006;**
H02J 2310/14; Y02B 70/30; Y02B 70/3225;
Y04S 20/222; Y04S 20/242

(86) Numéro de dépôt international:
**PCT/FR2019/052317**

(87) Numéro de publication internationale:
**WO 2020/070434 (09.04.2020 Gazette 2020/15)**

(54) **ESTIMATION D'UNE GRANDEUR PHYSIQUE PAR UN SYSTÈME DE MESURE DISTRIBUÉ**

SCHÄTZUNG EINER PHYSIKALISCHEN GRÖSSE DURCH EIN VERTEILTES MESSSYSTEM

ESTIMATION OF A PHYSICAL QUANTITY BY A DISTRIBUTED MEASUREMENT SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.10.2018 FR 1859197**

(43) Date de publication de la demande:
**11.08.2021 Bulletin 2021/32**

(73) Titulaire: **Voltalis**
**75008 Paris (FR)**

(72) Inventeurs:
• **AUTORD, Marc**
  **78930 GUERVILLE (FR)**
• **BINEAU, Mathieu**
  **78000 VERSAILLES (FR)**
• **HEINTZ, Bruno**
  **75015 PARIS (FR)**
• **OURY, Jean-Marc**
  **75007 PARIS (FR)**

(74) Mandataire: **Ipsilon**
  **Le Centralis**
  **63, avenue du Général Leclerc**
  **92340 Bourg-la-Reine (FR)**

(56) Documents cités:
  **FR-A1- 2 978 309**

**Description**

La présente invention concerne de manière générale l'estimation d'une grandeur physique variable dans le temps par un système de mesure distribué comportant une plateforme centralisée et un ensemble composé d'une pluralité d'équipements de mesure distribués, aptes chacun à mesurer une donnée locale représentative de ladite grandeur physique et à communiquer à distance avec ladite plateforme centralisée par l'intermédiaire d'un réseau de communication.

Un domaine d'application visé tout particulièrement, bien que non exclusivement, par l'invention est celui de la gestion et/ou de la surveillance de la consommation en électricité d'appareils électriques, par exemple des appareils électriques à usage domestique, situés chez un nombre particulièrement élevé de consommateurs et reliés à un réseau de distribution d'électricité.

Dans de tels systèmes, il est classique d'installer au moins un équipement de mesure sur une pluralité de sites (domiciles, bâtiments d'entreprises, collectivités...), relié localement à au moins un appareil électrique sous surveillance de façon à pouvoir effectuer, de préférence en continu, des mesures de consommation électrique de cet appareil électrique. Une plateforme centralisée dédiée, sous forme d'un ou de plusieurs serveurs, obtient alors, de préférence en temps réel, des échantillons de mesures de consommation électrique communiqués par chaque équipement de mesure local du système. La plateforme centralisée peut ainsi déterminer les courbes de charge élémentaires, c'est-à-dire la variation temporelle de la consommation relative à chacune des charges ou appareils électriques sous surveillance, et en déduire, par agrégation de ces courbes de charge élémentaires, une courbe de charge globale.

Pour un système dédié à la surveillance seule de la consommation en électricité, les équipements de mesure distribués sur les différents sites peuvent être typiquement des compteurs électriques dits intelligents, aptes à mesurer la puissance électrique consommée par un ou plusieurs appareils électriques de manière à délivrer périodiquement des échantillons de mesure de la consommation électrique.

La Demanderesse propose également un système distribué de modulation de la consommation d'un ensemble composé d'un nombre très élevé d'appareils électriques (tels que des chauffe-eau, des radiateurs électriques, des climatiseurs...) situés chez un grand nombre d'utilisateurs, dans lequel les différentes courbes de charge obtenues par des équipements de mesure distribués permettent notamment de proposer un service dit d'effacement diffus, par lequel il est possible de sélectionner en temps réel, dans l'ensemble des équipements de mesure reliés localement aux appareils électriques, un sous-ensemble d'équipements de mesure auxquels le système, en particulier la plateforme centralisée, va envoyer des ordres de coupure momentanée de fonctionnement, de manière à réduire la consommation d'énergie de l'ensemble d'une valeur de consigne donnée. Un système de ce type est par exemple dans la demande WO2008/017754, ou dans la demande WO2012/172242. Ce système, en étant également apte à moduler sélectivement, via des ordres de coupure et de redémarrage, l'alimentation de certains appareils électriques par analyse de la consommation d'un grand nombre d'utilisateurs, permet d'adapter la consommation électrique à la production d'électricité disponible à un instant donné.

Lorsque que les systèmes de mesure sont massivement distribués, avec un ensemble comportant un nombre très important d'équipements de mesure distribués, la connaissance de la grandeur physique agrégée à partir des échantillons de mesure prélevés par les différents équipements de mesure requiert la transmission d'un nombre très élevé, typiquement de centaines de milliers (voire plus), de mesures par les équipements de mesure. Quel que soit le réseau de communication utilisé pour la transmission des données, cela génère une occupation importante de la bande passante du réseau. En outre, pour certains types de réseau de communication tels que des réseaux cellulaires, les volumes de données nécessaires à cette transmission peuvent impliquer des coûts significatifs. Ce problème constitue en conséquence une limitation à l'augmentation du périmètre de ces systèmes, c'est-à-dire du nombre d'équipements de mesure distribués.

Le problème précédent est accru dans les systèmes de mesure de consommation électrique massivement distribués, tels que celui décrit dans les demandes WO2008/017754 et WO2012/172242 précitées, pour lesquels il est important de connaître en temps réel la courbe de charge agrégée exacte à partir de la transmission en temps réel d'un grand nombre de mesures de consommation.

Dans de tels systèmes, la plateforme centralisée obtient des échantillons de mesure de consommation électrique à une période d'échantillonnage généralement de l'ordre de la dizaine de minutes. Une courbe de charge agrégée plus précise pourrait être obtenue en réduisant la période d'échantillonnage, par exemple en utilisant une période d'échantillonnage fortement réduite, typiquement de l'ordre de la dizaine de secondes, voire de la seconde. Le nombre des mesures qui doivent être non seulement collectées mais également agrégées sur une période d'échantillonnage par la plateforme centralisée devient dans ce cas trop important.

Pour résoudre le problème lié au nombre important de mesures collectées, directement dépendant du nombre d'équipements de mesure compris dans l'ensemble et/ou de la fréquence d'échantillonnage des mesures, il est connu de pratiquer à un nombre limité de mesures collectées au sein d'un sous-ensemble, dit de sondage, puis d'estimer la grandeur physique, par exemple la courbe de charge globale, par extrapolation des mesures collectées à partir de ce sous-ensemble. La précision de l'estimation dépend très fortement de la façon dont le sous-ensemble de sondage a été constitué.

Or, à ce jour, les solutions connues reposent sur des techniques de sondage conventionnelles pour lesquelles la constitution d'un échantillon représentatif, c'est-à-dire ici, la sélection du sous-ensemble d'équipements de mesure sondés, se fait classiquement, une fois pour toutes et à l'initiative du sondeur, par pur aléa, par stratification, par grappe ou par la méthode des quotas.

Ces types de sondage génèrent donc la présélection d'une partie seulement des instruments de mesure constituant l'ensemble dans le système, dont l'appartenance à l'échantillon considéré comme représentatif est due à l'observation d'un comportement passé (consommation lors de la dernière heure, de la dernière journée, etc.) ou d'une configuration déterminée (équipement mesuré, tarification de l'abonné, localisation, etc.).

Cet échantillon ou sous-ensemble représentatif, quelle que soit la méthode de constitution employée, est statique, ou quasi-statique, c'est-à-dire que sa composition varie faiblement par rapport à la fréquence de remontée des mesures.

Or, au-delà de la difficulté notoire à sélectionner un sous-ensemble représentatif sur une période d'observation, il n'est pas garanti que cette représentativité observée dans le passé prédise convenablement des mesures à venir.

L'expérience montre que, pour qu'un sous-ensemble soit représentatif sur des observations à venir, il faut que le sous-ensemble sondé soit d'une très grande taille, ce qui limite considérablement les avantages du sondage.

On connait par ailleurs du document FR 2 978 309 A1 un système de mesure distribué comportant une plateforme centralisée et un ensemble composé d'une pluralité d'équipements de mesure distribués aptes chacun à communiquer à distance avec la plateforme centralisée par l'intermédiaire d'un réseau de communication, grâce auquel la puissance globale consommée est calculée grâce à un procédé comportant les étapes selon le préambule de la revendication 1.

La présente invention a pour but de pallier les inconvénients des systèmes utilisant les techniques de sondage conventionnelles précitées.

Pour ce faire, l'invention a pour objet un procédé d'estimation d'une grandeur physique variable dans le temps selon la revendication 1.

Ainsi, la présente invention permet de créer dynamiquement et aléatoirement, à chaque période d'échantillonnage, le sous-ensemble d'équipements de mesure qui va participer au sondage et permettre par agrégation une estimation précise et rapide de la grandeur physique. En outre, la création du sous-ensemble s'effectue par le biais seul des équipements de mesure qui décident ou non, de façon aléatoire, de participer au sondage à chaque période d'échantillonnage.

Selon un mode d'implémentation possible du procédé selon l'invention, la probabilité d'envoi $\pi_i$ associée à au moins un équipement de mesure dudit ensemble a une valeur variable en fonction de la valeur de l'échantillon $P_i$ de mesure effectuée et/ou de conditions de réalisation de la mesure et/ou de l'instant de la mesure; dans ce cas, si ledit au moins un équipement de mesure fait partie dudit sous-ensemble, ledit au moins un équipement de mesure transmet la probabilité d'envoi à la plateforme centralisée via ledit réseau de communication pendant l'étape de collecte, en même temps que l'échantillon de mesure $P_i$ de la donnée locale.

Selon un autre mode d'implémentation possible du procédé selon l'invention, la probabilité d'envoi $\pi_i$ est transmise à la plateforme centralisée par chaque équipement de mesure appartenant audit sous-ensemble via ledit réseau de communication pendant l'étape de collecte, en même temps que l'échantillon de mesure $P_i$ de la donnée locale.

Dans une implémentation possible, le procédé peut comporter en outre une étape de mise à jour de l'algorithme local de décision et/ou de la probabilité d'envoi $\pi_i$ associée à au moins un équipement de mesure dudit ensemble.

Dans certains cas, la période d'échantillonnage T peut être inférieure ou égale à 10 minutes.

La période d'échantillonnage T peut notamment être avantageusement sensiblement de l'ordre de la seconde ou de la dizaine de secondes, ce qui est particulièrement utile pour un système devant estimer en temps réel la grandeur physique sur une période d'échantillonnage.

L'invention a également pour objet un système de mesure distribué pour estimer une grandeur physique variable dans le temps selon la revendication 7.

La donnée locale est par exemple une puissance électrique soutirée par une charge locale comprenant un ou plusieurs appareils électriques domestiques raccordés à un réseau de distribution d'électricité, et la grandeur physique est alors la puissance électrique totale consommée.

L'invention sera mieux comprise à la lecture de la description qui suit, faite en référence aux figures annexées, dans lesquelles :

- la figure 1 donne un exemple d'architecture d'un système de mesure distribué apte à implémenter l'invention;
- la figure 2 illustre des étapes susceptibles d'être mises en œuvre dans un procédé d'estimation d'une grandeur physique conforme à l'invention, par exemple par le système de la figure 1.

Dans la suite de l'exposé, l'invention sera décrite dans le cadre de la détermination d'une courbe de charge globale comprenant une agrégation de courbes de charge élémentaires correspondant à l'évolution temporelle de la consommation électrique d'une pluralité d'équipements électriques. La grandeur physique à estimer est donc ici la puissance électrique totale consommée par une pluralité d'appareils électriques. Comme indiqué ci-avant, le principe de l'invention peut être néanmoins appliqué à d'autres grandeurs physiques, par exemple à d'autres types d'énergies consommées.

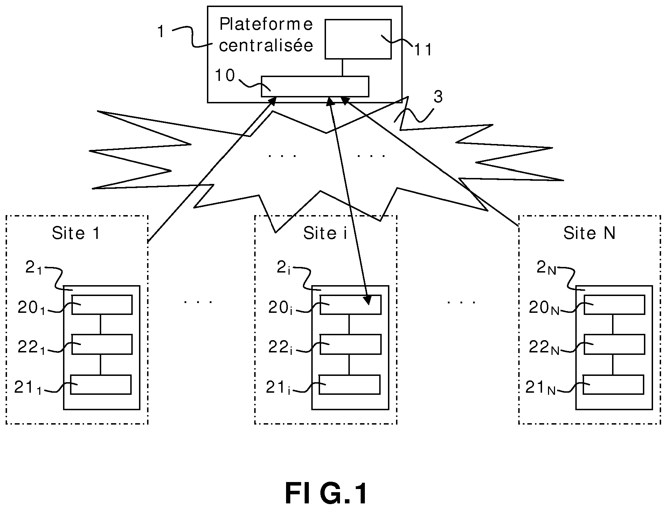

La figure 1 illustre l'architecture d'un système 1 de mesure distribué permettant l'estimation de la puissance électrique consommée par des appareils électriques (non représentés), par exemple à usage domestique, connectés à un réseau de distribution en électricité (non représenté) et situés sur un nombre N de sites. Le système comporte une plateforme centralisée 1, hébergée par un ou plusieurs serveurs Internet, et un ensemble composé ici de N équipements de mesure $2_1,...2_i,...2_N$ distribués sur les N sites. Dans la suite de l'exposé, l'indice i est utilisé pour toute référence à un équipement de mesure $2_i$ situé sur le site i, i étant un entier variant de 1 à au plus N.

Chaque équipement de mesure $2_i$ est apte à communiquer à distance avec la plateforme centralisée 1 par l'intermédiaire d'un réseau 3 de communication. A cet effet, chaque équipement de mesure $2_i$ comporte par exemple un modem $20_i$ de communication sans fil permettant d'établir avec un modem 10 de communication correspondant au niveau de la plateforme centralisée 1 une connexion de type téléphonie par paquet, tel que le GPRS, la 3G ou la 4G. Alternativement, la connexion peut s'effectuer via une liaison de type Ethernet.

Chaque équipement de mesure $2_i$ est en outre apte à mesurer la puissance électrique consommée localement par les appareils électriques auxquels il est relié, par l'intermédiaire d'un module $22_i$ de mesure des tensions et des courants. Les équipements de mesure $2_i$ sont par exemple des compteurs électriques intelligents installés sur chaque site i. Dans une autre architecture possible ou le système peut effectuer une modulation de la puissance électrique en proposant un service d'effacement diffus, chaque équipement de mesure $2_i$ est composé d'un ou plusieurs boîtiers tels que des boîtiers pilote et boîtiers modulateurs décrits dans les demandes WO2008/017754 et WO2012/172242 précitées, incorporées par référence. A la différence d'un compteur, ces équipements sont en outre aptes à exécuter des ordres de coupure/redémarrage de fonctionnement d'un ou plusieurs appareils électriques auxquels ils sont reliés, ordres qu'ils reçoivent de la plateforme centralisée pour la gestion d'effacements ponctuels.

Dans tous les cas, afin d'éviter une transmission importante de données, le système est configuré pour estimer la puissance totale consommée à partir d'échantillons de mesure effectués par un sous-ensemble d'équipements de mesure, ou sous-ensemble de sondage considéré comme représentatif. Plus précisément, le système est configuré pour implémenter les étapes suivantes :

- une étape de mesure, lors de laquelle chaque équipement de mesure $2_i$ de l'ensemble de N équipements mesure la puissance électrique Pi consommée localement ;

- une étape de collecte, lors de laquelle seul un nombre N' inférieur à N d'équipements de mesure 2j, correspondant au sous-ensemble de sondage, transmet à la plateforme centralisée 1 un échantillon de mesure de la puissance électrique $P_i$ consommée localement via le réseau 3 de communication sur une période d'échantillonnage T prédéterminée ; et

- une étape d'estimation, lors de laquelle la plateforme centralisée 1 estime la puissance consommée totale sur la période d'échantillonnage T à partir d'une agrégation des échantillons de mesure collectés.

A la différence des systèmes utilisant des techniques conventionnelles de sondage avec un sous-ensemble représentatif fixe, le système selon l'invention prévoit de changer, à chaque période d'échantillonnage T, le périmètre du sous-ensemble de sondage, c'est-à-dire le choix des équipements de mesures qui vont effectivement transmettre leur mesure lors de l'étape de collecte.

Pour ce faire, conformément à l'invention, chacun des N équipements de mesure $2_i$ exécute, à chaque période d'échantillonnage T, un algorithme local de décision mémorisé dans un module logiciel $21_i$ et apte à décider aléatoirement, sur la base d'une probabilité d'envoi $\pi_i$ associée à chaque équipement $2_i$ de mesure, si l'équipement de mesure correspondant va envoyer ou non son échantillon de mesure $P_i$ à la plateforme centralisée 1.

En d'autres termes, chaque équipement de mesure $2_i$ est apte à décider, de façon aléatoire, s'il va ou non faire partie du sous-ensemble de sondage transmettant les échantillons de mesure sur la période d'échantillonnage T.

Dans un mode de réalisation possible, tous les équipements de mesure $2_i$ comportent la même probabilité d'envoi $\pi_i$ prédéfinie sur la période T et le même algorithme local de décision.

L'algorithme local de décision peut suivre une loi de Bernoulli et implémenter par exemple les étapes suivantes :

- générer un nombre aléatoire, de valeur comprise par exemple entre 0 et 100 ;

- si le nombre aléatoire généré est inférieur à la valeur affectée au pourcentage de la probabilité d'envoi $\pi_i$, par exemple inférieure à 10 si la probabilité d'envoi $\pi_i$ est égale à 10%, l'équipement de mesure $2_i$ transmet l'échantillon de mesure Pi à la plateforme centralisée 1 (en d'autres termes l'équipement de mesure fait alors partie du sous-ensemble de sondage).

- sinon, l'équipement de mesure $2_i$ ne transmet pas l'échantillon de mesure $P_i$ à la plateforme centralisée 1.

Dans un autre mode de réalisation possible, la probabilité d'envoi $\pi_i$ peut avoir une valeur fixe, prédéfinie sur la période T, mais différente d'un équipement de mesure à l'autre.

Dans un autre mode de réalisation possible, la probabilité d'envoi $\pi_i$ pour un ou plusieurs équipements $2_i$ de mesure dudit ensemble (voire pour la totalité des équipements de mesure) a une valeur variable en fonction de la valeur de l'échantillon $P_i$ de mesure effectuée et/ou de conditions de réalisation de la mesure et/ou de l'instant de la mesure. Ainsi, à titre d'exemple non limitatif, on peut prévoir que la probabilité d'envoi $\pi_i$ pour un équipement $2_i$ de mesure soit égale à 0% si la valeur de l'échantillon $P_i$ de mesure effectuée sur la période d'échantillonnage considérée est nulle. En d'autres termes, cet équipement $2_i$ de mesure n'envoie pas les mesures nulles, et ne fera pas partie du sous-ensemble de sondage. Si l'équipement $2_i$ de mesure fait partie d'un système de modulation proposant le service d'effacement diffus, on peut également prévoir, à titre d'exemple, que la probabilité d'envoi $\pi_i$ pour cet équipement $2_i$ de mesure soit égale à 100% si la valeur de l'échantillon $P_i$ de mesure effectuée sur la période d'échantillonnage considérée n'est pas nulle alors qu'un ordre de coupure des appareils électriques reliés à cet équipement devrait être en cours d'exécution. En d'autres termes, un équipement $2_i$ de mesure peut choisir d'envoyer systématiquement sa mesure dès lors qu'il juge d'une situation anormale.

La plateforme centralisée doit, comme il sera apparent dans la suite, connaître la probabilité d'envoi $\pi_i$ correspondant à tout échantillon de mesure qu'elle collecte. Aussi, on prévoit que les équipements $2_i$ de mesure appartenant au sous-ensemble de sondage et dont la probabilité d'envoi varie, quelle qu'en soit la raison, transmettent leur probabilité d'envoi $\pi_i$ à la plateforme centralisée 1 via ledit réseau 3 de communication pendant l'étape 120 de collecte, en même temps que leur échantillon de mesure $P_i$.

Dans un autre mode de réalisation possible, on peut prévoir que la probabilité d'envoi $\pi_i$ prédéfinie soit transmise systématiquement, qu'elle soit variable ou non, à la plateforme centralisée 1 par chaque équipement $2_i$ de mesure appartenant audit sous-ensemble via ledit réseau 3 de communication pendant l'étape 120 de collecte, en même temps que l'échantillon de mesure $P_i$.

Il est possible de prévoir qu'au moins un ou plusieurs, voire la totalité des équipements de mesure de l'ensemble puisse réaliser des mises à jour de l'algorithme local de décision et/ou de la probabilité d'envoi $\pi_i$ prédéfinie. Les mises à jour peuvent être transmises par la plateforme centralisée 1. En variante, les mises à jour sont réalisées sur la base d'informations calculées ou mesurées en local par les équipements de mesure.

Une fois que la plateforme centralisée 1 a collecté les différents échantillons de mesure $P_i$ transmis par les N' équipements de mesure du sous-ensemble de sondage, et, le cas échéant, les probabilités d'envoi $\pi_i$ correspondantes, elle va pouvoir traiter ces échantillons au niveau d'un module de traitement 11, et notamment estimer la puissance totale P(T) consommée sur la période d'échantillonnage T à partir des échantillons de mesure $P_i$ collectés et de la probabilité d'envoi $\pi_i$ associée à chaque équipement de mesure appartenant audit sous-ensemble de sondage.

On montre notamment qu'une bonne estimation de la puissance totale P(T) consommée sur une période d'échantillonnage T peut être obtenue par la relation suivante :

$$P(T) = \sum_{i=1}^{N'} \frac{P_i(T)}{\pi_i(T)}$$

laquelle ne prend en compte que les N' équipements de mesure du sous-ensemble de sondage.

La relation précédente part bien entendu de l'hypothèse que les mesures transmises par les N' équipements sont toutes effectivement reçues. Dans le cas contraire, la relation s'applique au nombre de mesures réellement collectées.

L'expérience montre que dans le cas d'une valeur à estimer sur la durée (suite temporelle), la méthode de génération dynamique d'un sous-ensemble de sondage à chaque période d'échantillonnage T est bien plus précise que les méthodes dites statiques ou quasi statiques. Cette précision peut s'expliquer par le fait que le biais de sélection s'apparente à des fluctuations dues à la constitution dynamique du sous-ensemble de sondage, et que la moyenne des erreurs s'approche alors de zéro.

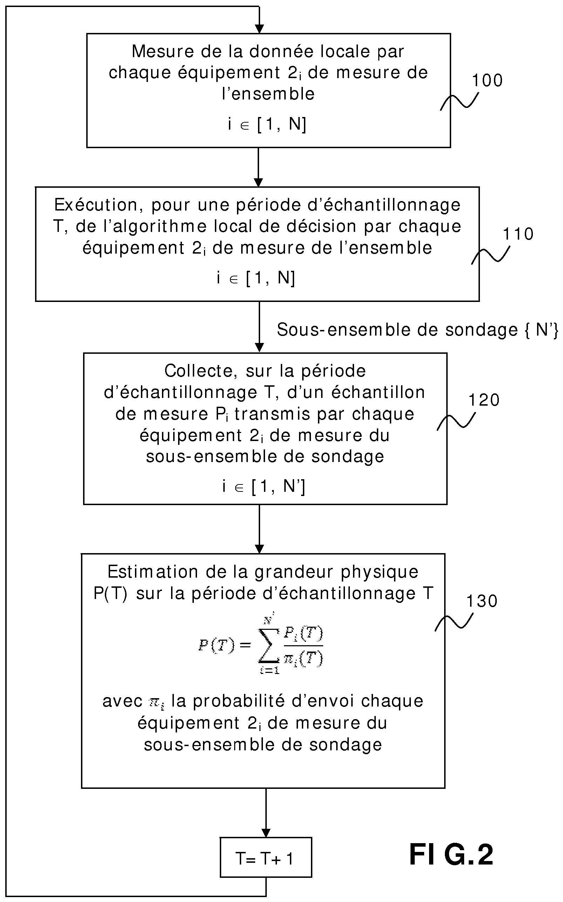

La figure 2 résume des étapes susceptibles d'être mises en œuvre dans un procédé d'estimation d'une grandeur physique conforme à l'invention, par exemple par le système de la figure 1 comportant N équipements de mesure $2_i$ distribués, et pour lequel la grandeur physique est la puissance électrique totale consommée sur une période d'échantillonnage T :

Le procédé d'estimation comporte une première étape 100 de mesure d'une donnée locale représentative de la grandeur physique à estimer par chacun des N équipements $2_i$ de mesure constituant l'ensemble de départ.

Lors d'une étape 110, chacun des N équipements $2_i$ de mesure de l'ensemble exécute son algorithme local de décision, afin de décider aléatoirement s'il va transmettre ou non un échantillon de mesure $P_i$ sur la période d'échantillonnage T considérée. Cette étape 110 permet de déterminer dynamiquement le sous-ensemble de sondage constitué de N' équipements $2_i$ de mesure qui ont chacun décidé, à l'issue de l'exécution de leur algorithme local de décision, de transmettre leur échantillon de mesure $P_i$ selon leur probabilité d'envoi $\pi_i$. Dans le cas où l'équipement de mesure considéré possède, comme mentionné précédemment, plusieurs valeurs possibles de probabilité d'envoi $\pi_i$, cette étape comporte en outre la sélection (non représentée) de la valeur de probabilité d'envoi qui sera effectivement associée à la mesure.

Une fois le sous-ensemble de sondage déterminé pour la période d'échantillonnage T considérée, le procédé se poursuit par une étape 120 de collecte, par la plateforme centralisée 1, des échantillons de mesure $P_i$ transmis par les seuls équipements 2i de mesure du sous-ensemble de sondage. Comme on l'a vu précédemment, la probabilité d'envoi peut ou doit dans certains cas être également transmise avec l'échantillon de mesure $P_i$ correspondant.

La dernière étape 130 comprend l'estimation de la grandeur physique P(T) sur la période d'échantillonnage T à partir des au plus N' échantillons $P_i$ de mesure collectés à l'étape 120 par la plateforme centralisée 1 et des probabilités d'envoi $\pi_i$ associées, de préférence par application de la relation

$$P(T) = \sum_{i=1}^{N'} \frac{P(T)_i}{\pi_i(T)}$$

Les différentes étapes sont réitérées à chaque période d'échantillonnage, de façon à obtenir à chaque fois un sous-ensemble de sondage différent.

Cela permet notamment de faire participer l'intégralité des équipements de mesure et de conserver la représentativité sur la durée.

La période d'échantillonnage T peut être de l'ordre de 10 minutes. Néanmoins, l'utilisation d'un sous-ensemble de sondage créé dynamiquement permet de réduire considérablement cette période d'échantillonnage. On a pu montrer notamment qu'il était possible d'estimer précisément une courbe de charge agrégée pour un système massivement distribué comportant une centaine de milliers de sites avec une période d'échantillonnage T de l'ordre de 10 secondes, voire de la seconde, sans engendrer de coûts conséquents en termes de communication des données.

La méthode d'estimation selon l'invention permet de réduire considérablement le nombre de sites devant envoyer des mesures (on passe de 80% pour une méthode de sondage classique avec sous-ensemble statique à environ 10% grâce à l'invention) tout en conservant les critères de précisions demandés aux solutions distribuées pour la participation aux services système.

Par rapport à une méthode de sondage classique, il n'est pas nécessaire ici de faire une analyse préalable du parc d'équipements de mesure pour sélectionner un sous-ensemble représentatif. Il n'est pas non plus nécessaire de posséder une connaissance préalable du parc (localisation, type de tarification, typologie de site, etc.), connaissance pas toujours accessible et dont la collecte est chronophage et coûteuse. De plus, la configuration du parc est sujette à évoluer (déménagements, travaux, etc.) et maintenir à jour une telle connaissance nécessite une allocation de ressources permanente.

En outre, il n'est pas non plus nécessaire de surveiller la possible défaillance des équipements de mesure sélectionnés dans le sous-ensemble de sondage puisque le sous-ensemble de sondage change à chaque période d'échantillonnage.

Chaque équipement de mesure fait partie à un moment ou un autre du sous-ensemble de sondage, ce qui permet d'améliorer la représentativité et par suite la qualité de l'estimation.

Dans le cas où les équipements de mesure ont une probabilité d'envoi variable, on augmente en outre l'information utile pour un volume de données transmises identique.

## Revendications

1. Procédé d'estimation d'une grandeur physique variable dans le temps *P(T)* par un système de mesure distribué comportant une plateforme centralisée (1) et un ensemble composé d'une pluralité d'équipements (2$_i$) de mesure distribués aptes chacun à communiquer à distance avec ladite plateforme centralisée (1) par l'intermédiaire d'un réseau (3) de communication, le procédé comportant une étape (100) de mesure, par chaque équipement (2$_i$) de mesure dudit ensemble, d'une donnée locale représentative de ladite grandeur physique *P(T)*, une étape (120) de collecte, sur une période d'échantillonnage T prédéterminée, d'échantillons de mesure provenant d'un sous-ensemble dudit ensemble dans laquelle chaque équipement de mesure appartenant audit sous-ensemble transmet à ladite plateforme centralisée (1) un échantillon de mesure $P_i$ de la donnée locale via ledit réseau (3) de communication, et une étape (130) d'estimation de ladite grandeur physique *P(T)* sur la période d'échantillonnage à partir d'une agrégation des échantillons de mesure $P_i$ collectés, le procédé étant **caractérisé en ce qu'il** comporte, à chaque période d'échantillonnage T, une phase (110) d'exécution, au niveau de chaque équipement (2$_i$) de mesure dudit ensemble, d'un algorithme (22$_i$) local de décision apte à décider aléatoirement et sur la base d'une probabilité d'envoi $\pi_i$ associée à chaque équipement (2$_i$) de mesure, si l'équipement de mesure correspondant fait partie dudit sous-ensemble en générant un nombre aléatoire et en comparant ce nombre aléatoire à ladite probabilité d'envoi, **et en ce que** ladite grandeur physique *P(T)* est estimée à chaque période d'échantillonnage T à partir des échantillons de mesure $P_i$ collectés et de la probabilité d'envoi $\pi_i$ associée à chaque équipement de mesure appartenant audit sous-ensemble par calcul selon la relation suivante

$$P(T) = \sum_{i=1}^{N'} \frac{P_i(T)}{\pi_i(T)}$$

dans laquelle N' est le nombre d'équipements de mesure du sous-ensemble.

2. Procédé selon la revendication 1, **caractérisé en ce que** la probabilité d'envoi $\pi_i$ associée à au moins un équipement ($2_i$) de mesure dudit ensemble a une valeur variable en fonction de la valeur de l'échantillon $P_i$ de mesure effectuée et/ou de conditions de réalisation de la mesure et/ou de l'instant de la mesure, et **en ce que** si ledit au moins un équipement ($2_i$) de mesure fait partie dudit sous-ensemble, ledit au moins un équipement de mesure transmet la probabilité d'envoi à la plateforme centralisée (1) via ledit réseau (3) de communication pendant l'étape (120) de collecte, en même temps que l'échantillon de mesure $P_i$ de la donnée locale.

3. Procédé selon la revendication 1, **caractérisé en ce que** la probabilité d'envoi $\pi_i$ est transmise à la plateforme centralisée (1) par chaque équipement ($2_i$) de mesure appartenant audit sous-ensemble via ledit réseau (3) de communication pendant l'étape (120) de collecte, en même temps que l'échantillon de mesure $P_i$ de la donnée locale.

4. Procédé selon l'une quelconque des revendications précédentes, **caractérisé en ce qu'**il comporte en outre une étape de mise à jour de l'algorithme local de décision et/ou de la probabilité d'envoi $\pi_i$ associée à au moins un équipement ($2_i$) de mesure dudit ensemble.

5. Procédé selon l'une quelconque des revendications précédentes **caractérisé en ce que** la période d'échantillonnage T est inférieure ou égale à 10 minutes.

6. Procédé selon la revendication 5, **caractérisé en ce que** la période d'échantillonnage T est de l'ordre de la seconde ou de la dizaine de secondes.

7. Système de mesure distribué pour estimer une grandeur physique variable dans le temps *P(T),* le système comportant une plateforme centralisée (1) et un ensemble composé d'une pluralité d'équipements ($2_i$) de mesure distribués aptes chacun à communiquer à distance avec ladite plateforme centralisée (1) par l'intermédiaire d'un réseau (3) de communication, le système étant configuré de sorte que, lors d'une étape (100) de mesure, chaque équipement ($2_i$) de mesure dudit ensemble est adapté à mesurer une donnée locale représentative de ladite grandeur physique *P(T),* lors d'une étape (120) de collecte, chaque équipement de mesure appartenant à un sous-ensemble dudit ensemble est adapté à transmettre à ladite plateforme centralisée (1) un échantillon de mesure $P_i$ de la donnée locale via ledit réseau (3) de communication sur une période d'échantillonnage T prédéterminée, et lors d'une étape (130) d'estimation, la plateforme centralisée (1) est adaptée à estimer ladite grandeur physique *P(T)* sur la période d'échantillonnage à partir d'une agrégation des échantillons de mesure collectés, **caractérisé en ce que** chaque équipement ($2_i$) de mesure dudit ensemble comporte un module logiciel ($22_i$) configuré pour exécuter, à chaque période d'échantillonnage, un algorithme local de décision apte à décider aléatoirement et sur la base d'une probabilité d'envoi $\pi_i$ associée à chaque équipement ($2_i$) de mesure, si l'équipement de mesure correspondant fait partie dudit sous-ensemble en générant un nombre aléatoire et en comparant ce nombre aléatoire à ladite probabilité d'envoi, **et en ce que** la plateforme centralisée (1) est configurée pour estimer à chaque période d'échantillonnage T la grandeur physique *P(T)* à partir des échantillons de mesure $P_i$ collectés et de la probabilité d'envoi $\pi_i$ associée à chaque équipement de mesure appartenant audit sous-ensemble par calcul selon la relation suivante

$$P(T) = \sum_{i=1}^{N'} \frac{P_i(T)}{\pi_i(T)}$$

dans laquelle N' est le nombre d'équipements de mesure du sous-ensemble.

8. Système selon la revendication 7, dans lequel la donnée locale est une puissance électrique soutirée par une charge locale comprenant un ou plusieurs appareils électriques domestiques raccordés à un réseau de distribution d'électricité, et la grandeur physique est la puissance électrique totale consommée.

**Patentansprüche**

1. Verfahren zur Schätzung einer zeitvariablen physikalischen Größe *P(T)* durch ein verteiltes Messsystem, das eine zentralisierte Plattform (1) und eine Anordnung aufweist, die aus einer Vielzahl verteilter Messausrüstungen ($2_i$) zusammengesetzt ist, die imstande sind, mit der zentralisierten Plattform (1) aus der Ferne über ein Kommunikationsnetz (3) zu kommunizieren, wobei das Verfahren einen Messschritt (100) eines lokalen Datenwerts durch jede Messausrüstung ($2_i$) der Anordnung, der für die physikalische Größe *P(T)* repräsentativ ist, einen Sammelschritt (120) über einen vorher festgelegten Samplingzeitraums T von Messproben, die von einer Unteranordnung der Anordnung kommen, wobei jede Messausrüstung, die zu der Unteranordnung gehört, an die zentralisierte Plattform (1) eine Mess-

probe $P_i$ des lokalen Datenwerts über das Kommunikationsnetz (3) übermittelt, und einen Schätzschritt (130) der physikalischen Größe $P(T)$ während des Samplingzeitraums ausgehend von einer Aggregation der gesammelten Messproben $P_i$ aufweist, wobei das Verfahren **dadurch gekennzeichnet ist, dass** es in jedem Samplingzeitraum T im Bereich jeder Messausrüstung ($2_i$) der Anordnung eine Ausführungsphase (110) eines lokalen Entscheidungsalgorithmus ($22_i$) aufweist, der imstande ist, zufallsbedingt und auf der Basis einer jeder Messausrüstung ($2_i$) zugeordneten Versandwahrscheinlichkeit $\pi_i$ durch Erzeugen einer Zufallszahl und durch Vergleichen dieser Zufallszahl mit der Versandwahrscheinlichkeit zu entscheiden, ob die entsprechende Messausrüstung Teil der Unteranordnung ist, und dass die physikalische Größe $P(T)$ in jedem Samplingzeitraum T auf der Basis der gesammelten Messproben $P_i$ und der jeder Messausrüstung, die zu der Unteranordnung gehört, zugeordneten Versandwahrscheinlichkeit $\pi_i$ durch Berechnung gemäß der folgenden Gleichung

$$P(T) = \sum_{i=1}^{N'} \frac{P_i(T)}{\pi_i(T)}$$

geschätzt wird, wobei N' die Anzahl der Messausrüstungen der Unteranordnung ist.

2. Verfahren nach Anspruch 1, **dadurch gekennzeichnet, dass** die mindestens einer Messausrüstung ($2_i$) der Anordnung zugeordnete Versandwahrscheinlichkeit $\pi_i$ einen variablen Wert in Abhängigkeit von dem ausgeführten Wert der Messprobe $P_i$ und/oder von den Durchführungsbedingungen der Messung und/oder vom Zeitpunkt der Messung hat und dass, wenn die mindestens eine Messausrüstung ($2_i$) Teil der Unteranordnung ist, die mindestens eine Messausrüstung die Versandwahrscheinlichkeit an die zentralisierte Plattform (1) über das Kommunikationsnetz (3) während des Sammelschritts (120) zur gleichen Zeit wie die Messprobe $P_i$ des lokalen Datenwerts überträgt.

3. Verfahren nach Anspruch 1, **dadurch gekennzeichnet, dass** die Versandwahrscheinlichkeit $\pi_i$ an die zentralisierte Plattform (1) von jeder zu der Unteranordnung gehörenden Messausrüstung ($2_i$) über das Kommunikationsnetz (3) während des Sammelschritts (120) zur gleichen Zeit wie die Messprobe $P_i$ des lokalen Datenwerts übertragen wird.

4. Verfahren nach einem der vorangehenden Ansprüche, **dadurch gekennzeichnet, dass** es ferner einen Aktualisierungsschritt des lokalen Entscheidungsalgorithmus und/oder der der mindestens einen Messausrüstung ($2_i$) der Anordnung zugeordneten Versandwahrscheinlichkeit $\pi_i$ aufweist.

5. Verfahren nach einem der vorangehenden Ansprüche, **dadurch gekennzeichnet, dass** der Samplingzeitraum T kleiner oder gleich 10 Minuten ist.

6. Verfahren nach Anspruch 5, **dadurch gekennzeichnet, dass** der Samplingzeitraum T in der Größenordnung der Sekunde oder der Dutzend Sekunden liegt.

7. Verteiltes Messsystem zur Schätzung einer zeitvariablen physikalischen Größe $P(T)$, wobei das System eine zentralisierte Plattform (1) und eine Anordnung aufweist, die aus einer Vielzahl verteilter Messausrüstungen ($2_i$) zusammengesetzt ist, die jeweils imstande sind, mit der zentralisierten Plattform (1) aus der Ferne über ein Kommunikationsnetz (3) zu kommunizieren, wobei das System derart ausgelegt ist, dass bei einem Messschritt (100) jede Messausrüstung ($2_i$) der Anordnung geeignet ist, während eines Sammelschritts (120) einen physikalischen Datenwert zu messen, der für die physikalische Größe $P(T)$ repräsentativ ist, wobei jede Messausrüstung, die zu der Unteranordnung der Anordnung gehört, geeignet ist, an die zentralisierte Plattform (1) eine Messprobe $P_i$ des lokalen Datenwerts über das Kommunikationsnetz (3) über einen vorher festgelegten Samplingzeitraums zu übertragen, und die zentralisierte Plattform (1) bei einem Schätzschritt (130) geeignet ist, die physikalische Größe $P(T)$ während des Samplingzeitraums auf der Basis einer Aggregation der gesammelten Messproben zu schätzen, **dadurch gekennzeichnet, dass** jede Messausrüstung ($2_i$) der Anordnung ein Softwaremodul ($22_i$) aufweist, das ausgelegt ist, um in jedem Samplingzeitraum einen lokalen Entscheidungsalgorithmus auszuführen, der imstande ist, zufallsbedingt und auf der Basis einer jeder Messausrüstung ($2_i$) zugeordneten Versandwahrscheinlichkeit $\pi_i$ durch Erzeugen einer Zufallszahl und durch Vergleichen dieser Zufallszahl mit der Versandwahrscheinlichkeit zu entscheiden, ob die entsprechende Messausrüstung Teil der Unteranordnung ist, und dass die zentralsierte Plattform (1) ausgelegt ist, um in jedem Samplingzeitraum T die physikalische Größe $P(T)$ auf der Basis der gesammelten Messproben $P_i$ und der jeder Messausrüstung, die zu der Unteranordnung gehört, zugeordneten Versandwahrscheinlichkeit $\pi_i$ durch Berechnung gemäß der folgenden Gleichung

$$P(T) = \sum_{i=1}^{N'} \frac{P_i(T)}{\pi_i(T)}$$

zu schätzen, wobei N' die Anzahl der Messausrüstungen der Unteranordnung ist.

8. System nach Anspruch 7, wobei der lokale Datenwert eine physikalische Leistung ist, die durch einen lokalen Verbraucher entnommen wird, der einen oder mehrere haustechnische elektrische Geräte umfasst, die an ein Stromverteilungsnetz angeschlossen sind, und die physikalische Größe die insgesamt verbrauchte elektrische Leistung ist.

**Claims**

1. A method for estimating a time-variable physical quantity $P(T)$ by means of a distributed measurement system having a centralized platform (1) and a set composed of a plurality of distributed measurement equipment items ($2_i$) each able to communicate remotely with said centralized platform (1) via a communication network (3), the method comprising a step (100) of measuring, by means of each measurement equipment item ($2_i$) of said set, a local datum representative of said physical quantity $P(T)$, a step (120) of collecting, over a predetermined sampling period T, measurement samples originating from a subset of said set in which each measurement equipment item belonging to said subset transmits, to said centralized platform (1), a measurement sample $P_i$ of the local datum via said communication network (3), and a step (130) of estimating said physical quantity $P(T)$ over the sampling period from an aggregate of the collected measurement samples $P_i$, the method being **characterized in that** it includes, in each sampling period T, a phase (110) of executing, at each measurement equipment item ($2_i$) of said set, a local decision algorithm ($22_i$) able to decide, randomly and based on a sending probability $\pi_i$ associated with each measurement equipment item ($2_i$), whether the corresponding measurement equipment item is part of said subset by generating a random number and by comparing this random number to said sending probability, **and in that** said physical quantity $P(T)$ is estimated in each sampling period T from the collected measurement samples $P_i$ and the sending probability $\pi_i$ associated with each measurement device belonging to said subset by calculation according to the following relationship

$$P(T) = \sum_{i=1}^{N'} \frac{P_i(T)}{\pi_i(T)}$$

in which N' is the number of measurement equipment items of the subset.

2. The method according to claim 1, **characterized in that** the sending probability $\pi_i$ associated with at least one measurement equipment item ($2_i$) of said set has a value that is variable according to the value of the measurement sample $P_i$ taken and/or conditions under which the measurement is taken and/or the time of the measurement, and **in that** if said at least one measurement equipment item ($2_i$) is part of said subset, said at least one measurement equipment item transmits the sending probability to the centralized platform (1) via said communication network (3) during the collection step (120), at the same time as the measurement sample $P_i$ of the local datum.

3. The method according to claim 1, **characterized in that** the sending probability $\pi_i$ is transmitted to the centralized platform (1) by each measurement equipment item ($2_i$) belonging to said subset via said communication network (3) during the collection step (120), at the same time as the measurement sample $P_i$ of the local datum.

4. The method according to any one of the preceding claims, **characterized in that** it further comprises a step of updating the local decision algorithm and/or the sending probability $\pi_i$ associated with at least one measurement equipment item ($2_i$) of said set.

5. The method according to any one of the preceding claims, **characterized in that** the sampling period T is shorter than or equal to 10 minutes.

6. The method according to claim 5, **characterized in that** the sampling period T is of the order of a second or of around ten seconds.

7. A distributed measurement system for estimating a time-variable physical quantity $P(T)$, the system comprising a centralized platform (1) and a set composed of a plurality of distributed measurement equipment items ($2_i$) each able to communicate remotely with said centralized platform (1) via a communication network (3), the system being configured such that, in a measurement step (100), each measurement equipment item ($2_i$) of said set measures a local datum representative of said physical quantity $P(T)$, in a collection step (120), each measurement equipment item belonging to a subset of said set transmits, to said centralized platform (1), a measurement sample $P_i$ of the local datum via said communication network (3) over a predetermined sampling period T, and, in an estimation step (130), the centralized platform (1) estimates said physical quantity $P(T)$ over the sampling period on the basis of an aggregate of the collected measurement samples, **characterized in that** each measurement device ($2_i$) of said set comprises a software module

($22_i$) configured to execute, in each sampling period, a local decision algorithm able to decide, randomly and based on a sending probability $\pi_i$ associated with each measurement equipment item ($2_i$), whether the corresponding measurement equipment item is part of said subset by generating a random number and by comparing this random number to said sending probability, **and in that** the centralized platform (1) is configured to estimate, in each sampling period T, the physical quantity *P(T)* from the collected measurement samples $P_i$ and the sending probability $\pi_i$ associated with each measurement device belonging to said subset by calculation according to the following relationship

$$P(T) = \sum_{i=1}^{N'} \frac{P_i(T)}{\pi_i(T)}$$

in which N' is the number of measurement equipment items of the subset.

8. The system according to claim 7, wherein the local datum is an electrical power drawn by a local load comprising one or more domestic electrical appliances connected to an electricity distribution network, and the physical quantity is the total electrical power consumed.

1 ⌇ Plateforme
centralisée ⌐──────┐ ⌐ 11
│      │
10 ⌐ ┌──────────┐  └──────┘
         └──────────┘    3

Site 1          Site i          Site N

$2_1$           $2_i$           $2_N$
$20_1$          $20_i$          $20_N$
$22_1$          $22_i$          $22_N$
$21_1$          $21_i$          $21_N$

# FIG.1

Mesure de la donnée locale par chaque équipement $2_i$ de mesure de l'ensemble

$i \in [1, N]$

100

Exécution, pour une période d'échantillonnage T, de l'algorithme local de décision par chaque équipement $2_i$ de mesure de l'ensemble

$i \in [1, N]$

110

Sous-ensemble de sondage { N'}

Collecte, sur la période d'échantillonnage T, d'un échantillon de mesure $P_i$ transmis par chaque équipement $2_i$ de mesure du sous-ensemble de sondage

$i \in [1, N']$

120

Estimation de la grandeur physique P(T) sur la période d'échantillonnage T

$$P(T) = \sum_{i=1}^{N'} \frac{P_i(T)}{\pi_i(T)}$$

avec $\pi_i$ la probabilité d'envoi chaque équipement $2_i$ de mesure du sous-ensemble de sondage

130

T= T+ 1

FIG.2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008017754 A
- WO 2012172242 A

- FR 2978309 A1